# EUROPEAN PATENT APPLICATION

(11) **EP 4 516 961 A1**
(43) Date of publication of application: **05.03.2025**
(21) Application number: 23796676.7
(22) Date of filing: 14.04.2023
(51) Int. Cl.: C23C 16/34, C23C 16/36, C23C 16/40, C23C 16/30, C23C 16/455, C23C 16/32, C07F 7/10

(54) **SILICON PRECURSOR COMPOUND AND PREPARATION METHOD THEREFOR, AND SILICON-CONTAINING THIN FILM PREPARATION METHOD USING SILICON PRECURSOR**

(30) Priority: 25.04.2022 KR 20220050831
(71) Applicant: Merck Patent GmbH, 64293 Darmstadt (DE)
(72) Inventor: YANG, Byeong-Il, Daejeon 34402 (KR); JEONG, Hee-Yeon, Jecheon-si, Chungcheongbuk-do 27172 (KR); SEONG, Yeong-Ju, Daejeon 34046 (KR); CHEON, Seong-Hak, Jeungpyeong-gun, Chungcheongbuk-do 27938 (KR); KIM, Joo-Yong, Siheung-si, Gyeonggi-do 14985 (KR); BYUN, Young-Hun, Jeungpyeong-gun, Chungcheongbuk-do 27945 (KR)
(74) Representative: Merck Patent Association
(86) International application number: PCT/KR2023/005085
(87) International publication number: WO 2023/211027

(57) **Abstract**

The present invention relates to a novel silicon precursor compound enabling a silicon-containing thin film having excellent quality to be prepared, and a preparation method therefor, and a silicon-containing thin film preparation method using the silicon precursor compound.

## Description

### Technical Field

The present invention relates to a silicon precursor compound, to a method for preparing the same, and to a method for preparing a silicon-containing thin film using a silicon precursor compound.

### Background Art

Silicon-containing thin films, such as films of silicon oxide, silicon nitride, silicon oxynitride, and silicon carbonitride, are those among the thin films that are essential for operating microelectronic devices such as semiconductors as well as non-semiconductor (logic).

In recent years, in accordance with the high integration of semiconductor devices, silicon-containing thin films with various performances have been required. As the aspect ratio increases with the high integration of semiconductor devices, there has been a problem in that the deposition of a silicon-containing thin film using a conventional silicon precursor compound does not meet the required performance.

Atomic layer deposition (ALD) or chemical vapor deposition (CVD) is widely used to prepare silicon-containing thin films. Atomic layer deposition (ALD) among the above is a method that sequentially supplies a silicon compound gas and a reactant gas necessary for film formation, and it has the advantage of being able to form a silicon-containing thin film with a uniform thickness even on a highly uneven surface. Thus, atomic layer deposition (ALD) is widely utilized.

The mechanisms of chemical vapor deposition (CVD) and atomic layer deposition (ALD) are different from each other. Silicon precursors used in the preparation of silicon-containing thin films are of various types depending on various process conditions and their physical and chemical properties.

### Disclosure of Invention

### Technical Problem

An object of the present invention is to provide a novel silicon precursor compound that is advantageous for preparing a silicon-containing thin film with excellent quality and a method for preparing the same.

In addition, another object is to provide a method for preparing a silicon-containing thin film using such a silicon precursor compound.

### Technical Solution

The silicon precursor compound of the present invention for accomplishing the above object is characterized in that it is represented by the following Formula 1.

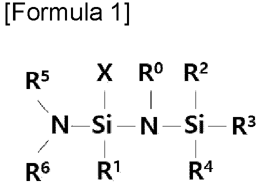

In Formula 1, R⁰, R⁵, and R⁶ are each independently a linear or branched, saturated or unsaturated hydrocarbon group having 1 to 4 carbon atoms or an isomer thereof, R¹, R², R³, and R⁴ are each independently hydrogen (H), a halogen, or a linear or branched, saturated or unsaturated hydrocarbon group having 1 to 4 carbon atoms, and X is hydrogen (H) or a halogen.

The silicon precursor compound of the present invention is preferably selected from the following compounds (1) to (36).

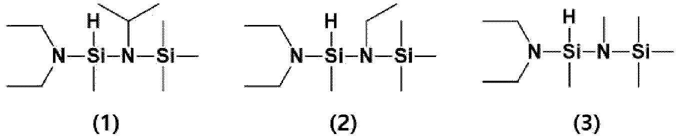

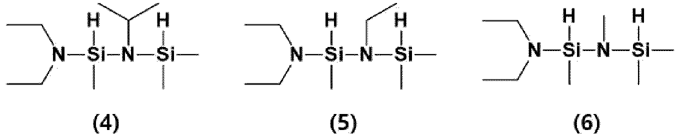

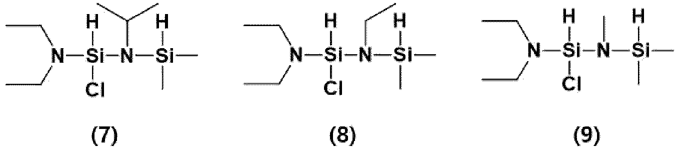

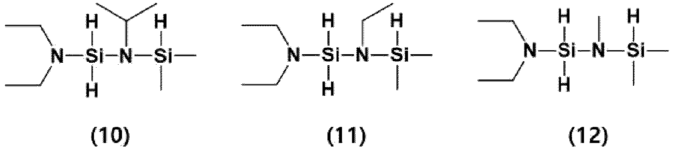

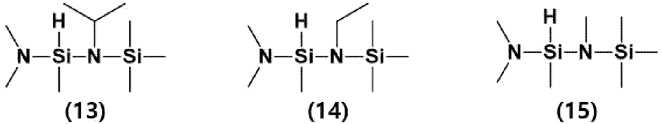

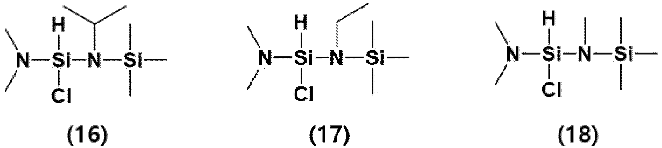

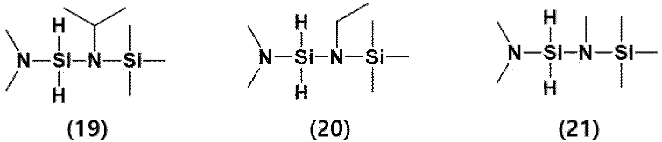

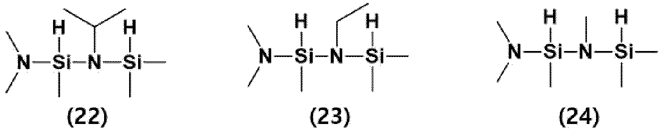

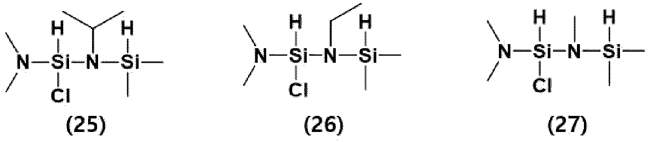

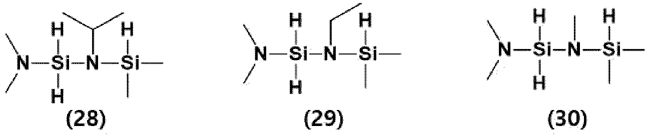

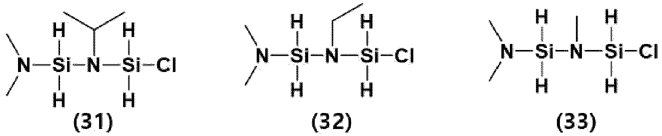

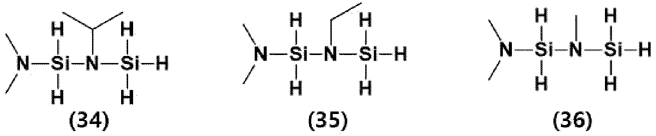

The method for preparing a silicon precursor compound of the present invention may comprise a first step of reacting a chlorosilane derivative with a primary amine to form a first compound, a second step of reacting the first compound with an alkyl-lithium (Alkyl-Li) to form a second compound comprising lithium, and a third step of reacting the second compound with a silane compound to prepare a silicon precursor compound represented by Formula 1.

The first compound is preferably a compound represented by the following Formula 7.

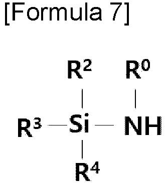

In Formula 7, R⁰ is each independently a linear or branched, saturated or unsaturated hydrocarbon group having 1 to 4 carbon atoms or an isomer thereof; and R², R³, and R⁴ are each independently hydrogen (H), a halogen, or a linear or branched, saturated or unsaturated hydrocarbon group having 1 to 4 carbon atoms.

In the method for preparing a silicon precursor compound of the present invention, when X and R₁ in the silicon precursor compound represented by Formula 1 are each a halogen, it may comprise a fourth step of reacting it with a metal hydride (MH).

In the method for preparing a silicon precursor compound of the present invention, the silane compound may be produced by reacting a chlorosilane derivative with a secondary amine.

The silicon precursor compound of Formula 1 prepared according to the method for preparing a silicon precursor compound of the present invention is selected from the above compounds (1) to (36).

In order to accomplish another object, the method for preparing a silicon-containing thin film according to the present invention may form a silicon-containing thin film using the silicon precursor compound represented by Formula 1.

In the method for preparing a silicon-containing thin film of the present invention, the silicon precursor compound is preferably selected from the above compounds (1) to (36).

In the method for preparing a silicon-containing thin film according to the present invention, the silicon-containing thin film may be deposited by chemical vapor deposition (CVD) or atomic layer deposition (ALD). The atomic layer deposition in the present invention may comprise plasma-enhanced atomic layer deposition.

The silicon-containing thin film may be any one selected from the group consisting of a silicon oxide film (SiO₂), a silicon oxycarbide film (SiOC), a silicon nitride film (SiN), a silicon oxynitride film (SiON), a silicon carbonitride film (SiCN), and a silicon carbonized film (SiC).

The silicon-containing thin film according to the present invention may be formed at a temperature of about 500°C or lower.

According to an embodiment of the method for preparing a silicon-containing thin film of the present invention, a silicon oxide (SiO₂) film may be formed by atomic layer deposition. The atomic layer deposition according to an embodiment comprises providing a substrate to a reactor; introducing the silicon precursor compound according to the present invention into the reactor; purging the reactor with a purge gas; introducing an oxygen source into the reactor to react with the silicon precursor compound according to the present invention to form a silicon oxide film; and purging the reactor with the purge gas.

The purge gas according to an embodiment is used to remove unconsumed reactants and reaction by-products and is preferably selected from the group consisting of nitrogen, helium, argon, and mixtures thereof, but it is not limited thereto.

The oxygen source according to an embodiment is preferably selected from the group consisting of oxygen, peroxide, oxygen plasma, water vapor, water vapor plasma, hydrogen peroxide, ozone source, and mixtures thereof, but it is not limited thereto. Preferably, the oxygen source may comprise plasma, and the plasma may be generated *in situ.*

In addition, the atomic layer deposition according to an embodiment may be carried out at one or more temperatures of about 500°C or lower. In such an event, the lower limit of the temperature may be appropriately selected by a person of ordinary skill in the art depending on the type of oxygen source used. Preferably, a silicon oxide film may be formed at one or more temperatures of about 300°C to 500°C.

According to another embodiment of the method for preparing a silicon-containing thin film of the present invention, a silicon nitride (SiN) film may be formed by plasma-enhanced atomic layer deposition. The atomic layer deposition according to an embodiment comprises providing a substrate to a reactor; introducing the silicon precursor compound according to the present invention into the reactor; purging the reactor with a purge gas; introducing a nitrogen-containing plasma source and an inert gas into the reactor to react with the silicon precursor compound according to the present invention to form a silicon nitride film; and purging the reactor with the purge gas.

The purge gas according to an embodiment is used to remove unconsumed reactants and reaction by-products and is preferably selected from the group consisting of nitrogen, helium, argon, and mixtures thereof, but it is not limited thereto.

The nitrogen-containing plasma source according to an embodiment is preferably selected from the group consisting of nitrogen plasma, nitrogen and argon mixed plasma (nitrogen/argon plasma), ammonia plasma, nitrogen and ammonia mixed plasma (nitrogen/ammonia plasma), ammonia and helium mixed plasma (ammonia/helium plasma), ammonia and argon mixed plasma (ammonia/argon plasma), ammonia and nitrogen mixed plasma (ammonia/nitrogen plasma), NF₃ plasma, organic amine plasma, and mixtures thereof, but it is not limited thereto.

In addition, the plasma-enhanced atomic layer deposition according to an embodiment may be carried out at one or more temperatures of about 400°C or lower. In such an event, the lower limit of the temperature may be appropriately selected by a person of ordinary skill in the art depending on the type of nitrogen-containing plasma source used. Preferably, a silicon nitride film may be formed at one or more temperatures of about 150°C to 350°C, more preferably, at a temperature of about 250°C.

### Advantageous Effects of Invention

The silicon precursor compound of the present invention exhibits sufficient volatility to be applied to both atomic layer deposition (ALD) and chemical vapor deposition (CVD) for preparing silicon-containing thin films. In particular, since it can be deposited at high temperatures and has a high deposition rate, it has the effect of being able to prepare silicon-containing thin films with high quality.

However, the effects of the present invention are not limited to those mentioned above.

### Brief Description of Drawings

Fig. 1 shows a hydrogen nuclear magnetic resonance (¹H-NMR) spectrum of the silicon precursor compound prepared according to Example 1 of the present invention.
Fig. 2 shows a hydrogen nuclear magnetic resonance (¹H-NMR) spectrum of the silicon precursor compound prepared according to Example 2 of the present invention.
Fig. 3 is a graph showing the results of thermogravimetric analysis (TGA) of the silicon precursor compounds prepared according to Examples 1 and 2 of the present invention.
Fig. 4 is a graph showing the results of measuring the vapor pressure of the silicon precursor compounds prepared according to Examples 1 and 2 of the present invention.
Fig. 5 is a graph showing the order of each pulse in the deposition process of a silicon nitride thin film.
Fig. 6 is a graph showing the deposition rate of a silicon nitride thin film with respect to the substrate temperature.
Fig. 7 is a graph showing the order of each pulse in the deposition process of a silicon oxide film.
Fig. 8 is a transmission electron microscope (TEM) photograph of a silicon oxide film deposited at a substrate temperature of 400°C.
Fig. 9 is a graph showing the deposition rate of a silicon oxide film with respect to the substrate temperature.
Fig. 10 is a graph showing the composition of a silicon oxide thin film at a substrate temperature of 400°C.

### Embodiments for Carrying out the Invention

Hereinafter, the silicon precursor compound, the method for preparing the same, and the method for preparing a silicon-containing thin film using a silicon precursor compound according to the present invention will be described in detail.

In the present specification, the term "about" is intended to cover ±5% of the number defined.

The silicon precursor compound of the present invention may be represented by the following Formula 1.

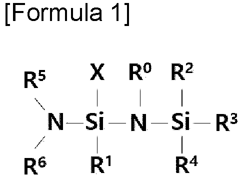

In Formula 1, R⁰, R⁵, and R⁶ are each independently a linear or branched, saturated or unsaturated hydrocarbon group having 1 to 4 carbon atoms or an isomer thereof, R¹, R², R³, and R⁴ are each independently hydrogen (H), a halogen, or a linear or branched, saturated or unsaturated hydrocarbon group having 1 to 4 carbon atoms, and X is hydrogen (H) or a halogen.

The hydrocarbon groups in R⁰, R¹, R², R³, R⁴, R⁵, and R⁶ may each independently be any one selected from the group consisting of a methyl group, an ethyl group, an n-propyl group, an iso-propyl group, an n-butyl group, an iso-butyl group, a sec-butyl group, a tert-butyl group, and isomers thereof.

The halogen may be any one selected from the group consisting of chlorine (CI), bromine (Br), iodine (I), and fluorine (F). Chlorine (CI) is preferable among the above.

Specifically, it is preferable that R⁰ is any one selected from a methyl group (Me), an ethyl group (Et), and an iso-propyl group (^{iso}Pr), R¹, R², R³, and R⁴ are each independently any one selected from hydrogen (H), chlorine (CI), and a methyl group (Me), R⁵ and R⁶ are each independently a methyl group (Me) or an ethyl group (Et), and X is hydrogen (H) or chlorine (CI).

The silicon precursor compound of the present invention may be prepared by a method as shown in Reaction Scheme 1 or Reaction Scheme 2 below.

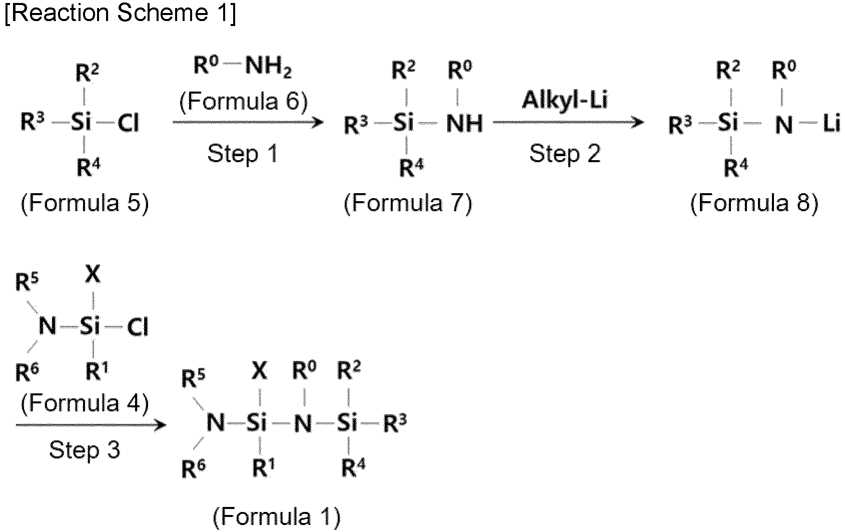

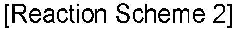

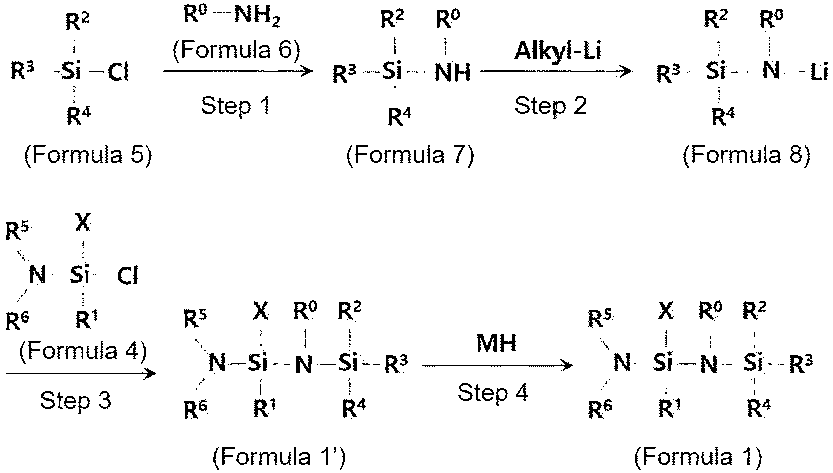

The method for preparing a silicon precursor compound according to Reaction Scheme 1 may be carried out in a sequence of a first step of reacting a chlorosilane derivative represented by Formula 5 with a primary amine represented by Formula 6 to form a first compound represented by Formula 7, a second step of reacting the first compound with an alkyl-lithium (Alkyl-Li) to form a second compound represented by Formula 8, and a third step of reacting the second compound with a silane compound represented by Formula 4 to prepare a silicon precursor compound represented by Formula 1.

In this specification, the first compound and the second compound are terms used only for the purpose of distinguishing the compounds formed at each step in the method for preparing a silicon precursor compound.

In the method for preparing a silicon precursor, in the first step, a triorganochlorosilane as a chlorosilane derivative is reacted with a primary amine at a low temperature of about -40°C in a non-polar solvent to perform a substitution reaction of Cl and an amine, followed by filtration and distillation under a reduced pressure to form a compound of Formula 7.

In the second step, the compound of Formula 7 formed in the first step is reacted with an alkyl-lithium (alkyl-Li) at a low temperature of about -40°C in a non-polar solvent to perform a Li substitution reaction to form a compound of Formula 8.

The alkyl-Li is lithium containing an alkyl group having 1 to 10 carbon atoms. Examples thereof include methyl lithium, ethyl lithium, propyl lithium, butyl lithium, and isobutyl lithium.

In the third step, after a reaction with a silane compound represented by Formula 4 to form a silicon precursor compound represented by Formula 1, the salt (LiCl) as a product of the reaction and unreacted substances are removed through filtration, and distillation under a reduced pressure is performed to obtain a silicon precursor compound represented by Formula 1. Another method for preparing a silicon precursor compound according to Reaction Scheme 2 may be carried out in the same manner as in Reaction Scheme 1. When X and R¹ in the silicon precursor compound represented by Formula 1' in Reaction Scheme 2 are each a halogen selected from fluorine (F), chlorine (CI), bromine (Br), or iodine (I), a fourth step of reacting with a metal hydride (MH) as a reducing agent is further carried out.

The metal hydride (MH) may be at least one selected from lithium hydride (LiH), sodium hydride (NaH), lithium boron hydride (LiBH₄), lithium aluminum hydride (LiAlH₄), sodium aluminum hydride (NaAlH₄), and sodium boron hydride (NaBH₄). For example, lithium hydride (LiH) as a metal hydride (MH) may be used by reacting with tetrahydrofuran (THF).

Preferably, the fourth step is carried out when X and R¹ in Formula 1' are chlorine (CI).

In the method for preparing a silicon precursor compound according to Reaction Scheme 1 or 2, as shown in the following Reaction Scheme 3, a chlorosilane derivative represented by Formula 2 is reacted with a secondary amine of Formula 3 at a low temperature of about -40°C in a non-polar solvent to perform a substitution reaction of Cl and an amine, followed by filtration and distillation under a reduced pressure to form a compound of Formula 4.

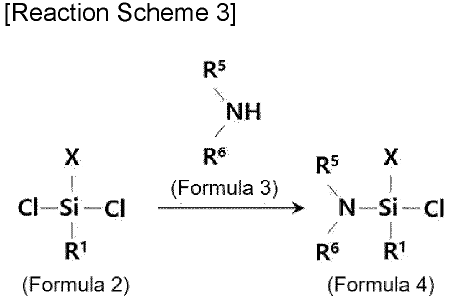

In the formulae of Reaction Schemes 1 to 3, R⁰, R⁵, and R⁶ are each independently a linear or branched, saturated or unsaturated hydrocarbon group having 1 to 4 carbon atoms or an isomer thereof, R¹, R², R³, and R⁴ are each independently hydrogen (H), a halogen, or a linear or branched, saturated or unsaturated hydrocarbon group having 1 to 4 carbon atoms, and X is hydrogen (H) or a halogen.

Preferably, in the formulae of Reaction Scheme 1, R⁰ may be any one selected from a methyl group (Me), an ethyl group (Et), and an iso-propyl group (^{iso}Pr), R¹, R², R³, and R⁴ may each independently be any one selected from hydrogen (H), chlorine (CI), and a methyl group (Me), R⁵ and R⁶ may each independently be a methyl group (Me) or an ethyl group (Et), and X may be hydrogen (H) or chlorine (CI).

As the non-polar solvent used in Reaction Schemes 1 to 3, hexane, n-pentane, or the like may be used, but it is not limited thereto. A non-polar solvent commonly used by a person of ordinary skill in the art can be used.

As a preferred example, the silicon precursor compound of the present invention is selected from the following compounds (1) to (36).

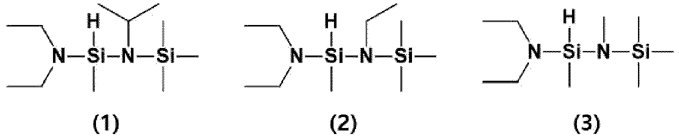

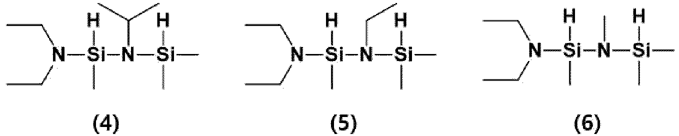

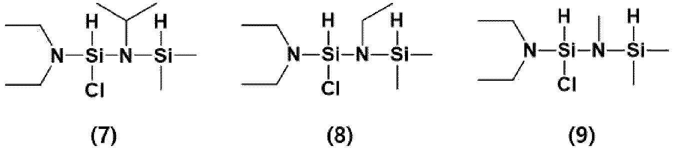

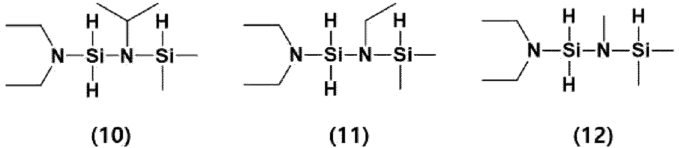

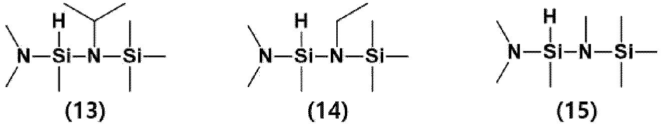

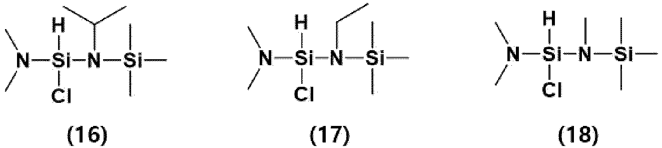

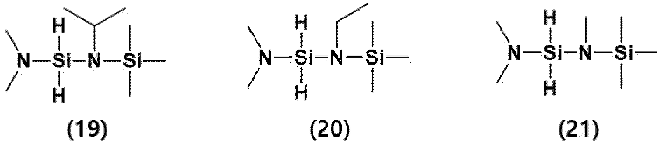

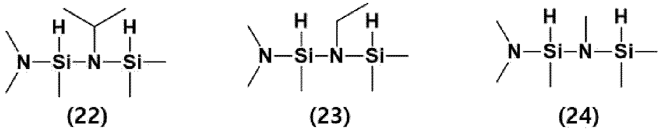

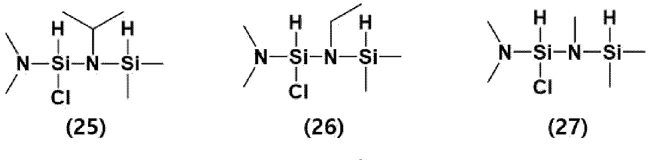

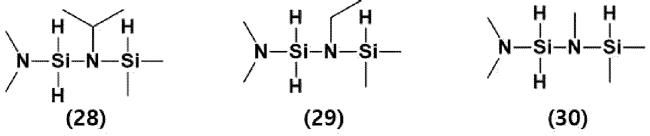

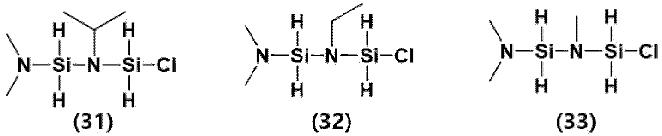

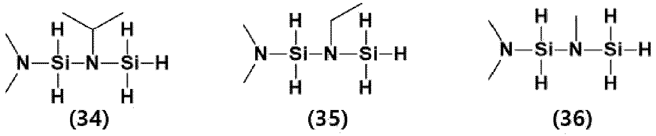

In addition, in the method for preparing a silicon-containing thin film of the present invention, a silicon-containing thin film can be formed using the silicon precursor compound represented by Formula 1 by chemical vapor deposition (CVD) or atomic layer deposition (ALD).

The silicon-containing thin film may be formed as any one selected from the group consisting of a silicon oxide film (SiO₂), a silicon oxycarbide film (SiOC), a silicon nitride film (SiN), a silicon oxynitride film (SiON), a silicon carbonitride film (SiCN), and a silicon carbonized film (SiC).

Hereinafter, the present invention will be described in more detail with reference to examples.

### [Example 1]

First, for 1-chloro-diethylamino-methylsilazane as a silane compound required for the preparation of a silicon precursor compound, a 1-liter flask in an anhydrous and inert atmosphere was charged with 217 g (1.89 moles) of dichloromethylsilane (CH₃SiHCl₂) and 2,722 g (20 moles) of n-pentane. While the temperature was maintained at -40°C, 283 g (3.87 moles) of diethylamine ((CH₃CH₂)₂NH) was slowly added, followed by stirring for 3 hours. Upon completion of the stirring, the diethylamine hydrochloride salt ((CH₃CH₂)₂NH₃Cl) was removed through filtration, and 220 g (1.45 moles) of chlorodiethylaminomethylsilazane ((CH₃CH₂)₂NCH₃SiHCl) (yield: 77%) was obtained through distillation under a reduced pressure.

¹H NMR (C₆D₆): δ 0.28(s, 3H (-Si***CH₃***)), 0.86(m, 6H (-(N(CH₂***CH₃***)₂)), 2.69(m, 4H (-N(***CH₂***CH₃)₂)), 5.07 (m, 1H (-Si***H***))

In the first step, isopropylaminotrimethylsilazane was prepared. A 1-liter flask in an anhydrous and inert atmosphere was charged with 220 g (2.03 moles) of chlorotrimethylsilane ((CH₃)₃SiCl) and 2,190 g (30 moles) of n-pentane. While the temperature was maintained at -40°C, 251 g (4.25 moles) of isopropylamine ((CH₃)₂CHNH₂) was slowly added, followed by stirring for 3 hours. Upon completion of the stirring, the isopropylamine hydrochloride salt ((CH₃)₂CHNH₃Cl) was removed through filtration, followed by distillation under a reduced pressure to obtain 205 g (1.5 moles) of isopropylaminotrimethylsilazane ((CH₃)₂CHNHSi(CH₃)₃) (yield: 77%).

¹H NMR (C₆D₆): δ 0.06(s, 6H (Si***CH₃***)₃), 0.96(d, 6H (NCH(***CH₃***)₂)), 2.92(m, 1H (N***CH***(CH₃)₂))

In the second step, a 1-liter flask in an anhydrous and inert atmosphere was charged with 161 g (1.11 moles) of isopropylaminotrimethylsilazane ((CH₃)₂CHNHSi(CH₃)₃) prepared in the first step and 950 g (11.0 moles) of hexane. While the temperature was maintained at -40°C, 470 ml (1.17 mole) of 2.5 M n-butyllithium (n-BuLi) was slowly added. The temperature of the reaction solution was then gradually raised to room temperature, followed by stirring for 12 hours at room temperature. While the temperature of the mixed solution was maintained at -20°C again, 168 g (1.11 moles) of 1-chloro-diethylamino-methylsilazane ((CH₃CH₂)₂NCH₃SiHCl) was slowly added, followed by stirring for 6 hours or longer. Upon completion of the stirring, the lithium chloride (LiCl) salt was removed through filtration. The obtained filtrate was distilled under a reduced pressure to obtain 190 g (yield: 70%) of diethylaminoisopropyltetramethyldisilazane ((CH₃CH₂)₂NCH₃HSiNCH(CH₃)₂Si(CH₃)₃) as a silicon precursor compound.

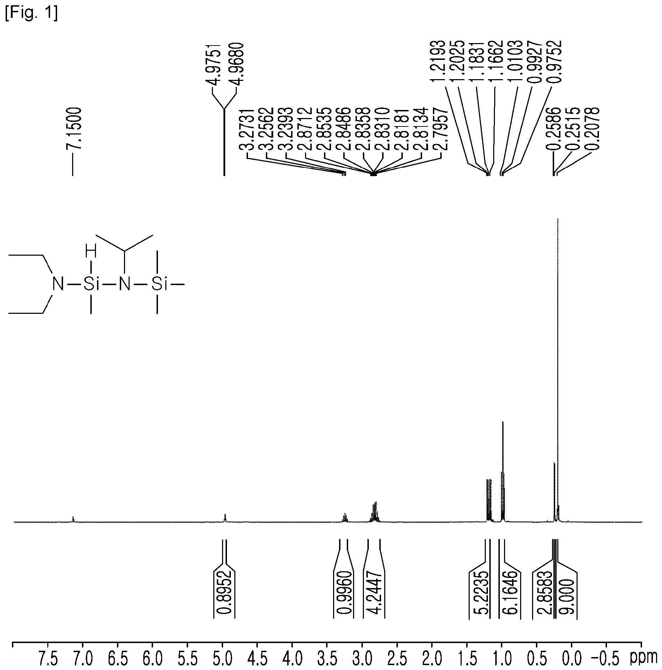

Fig. 1 shows a hydrogen nuclear magnetic resonance (¹H-NMR) spectrum of the silicon precursor compound prepared according to Example 1 of the present invention. As shown in Fig. 1, the silicon precursor compound prepared in Example 1 was confirmed to be diethylaminoisopropyltetramethyldisilazane.

¹H NMR (C₆D₆): δ 0.20(s, 9H (-Si(***CH₃***)***₃***), 0.25(d, 3H (-SiH***CH₃***)), 0.99(m, 6H (-SiN(CH₂***CH₃***)₂)), 1.18(m, 6H (-NCH(***CH₃***)₂)), 2.83(m, 4H (-SiN(***CH₂***CH₃)₂)), 3.25(m, 1H (-N***CH***(CH₃)₂)), 4.96(m, 1H (-Si***H***))

### [Example 2]

In Example 2, dimethylaminoisopropyltetramethyldisilazane of compound (13) was prepared as a silicon precursor compound.

First, for chloro-dimethylamino-methylsilazane as a silane compound required for the preparation of a silicon precursor compound, a 1-liter flask in an anhydrous and inert atmosphere was charged with 400 g (3.48 moles) of dichloromethylsilane (CH₃SiHCl₂) and 4,516 g (62.59 moles) of n-pentane. While the temperature was maintained at -40°C, 313 g (6.95 moles) of dimethylamine ((CH₃)₂NH) was slowly added, followed by stirring for 3 hours. Upon completion of the stirring, the dimethylamine hydrochloride salt ((CH₃)₂NH₃Cl) was removed through filtration, and 320 g (2.59 moles) of chlorodimethylaminomethylsilazane ((CH₃)₂NCH₃SiHCl) (yield: 74%) was obtained through distillation under a reduced pressure.

¹H NMR (C₆D₆): δ 0.23(d, 3H (-Si***CH₃***)), 2.25(m, 6H (-(N(***CH₃***)₂)), 5.0(m, 1H (-Si***H***))

In the first step of Example 2, isopropylaminotrimethylsilazane was prepared in the same manner as in Example 1.

In the second step of Example 2, a 1-liter flask in an anhydrous and inert atmosphere was charged with 220 g (1.51 moles) of isopropylaminotrimethylsilazane ((CH₃)₂CHNHSi(CH₃)₃) prepared in the first step and 1,304 g (15.1 moles) of hexane. While the temperature was maintained at -40°C, 641 ml (1.59 mole) of 2.5 M n-butyllithium (n-BuLi) was slowly added. The temperature of the reaction solution was then gradually raised to room temperature, followed by stirring for 12 hours at room temperature. While the temperature of the mixed solution was maintained at - 20°C again, 187 g (1.51 moles) of chloro-dimethylamino-methylsilazane ((CH₃)₂N CH₃SiHCl) was slowly added, followed by stirring for 6 hours or longer. Upon completion of the stirring, the lithium chloride (LiCl) salt was removed through filtration. The obtained filtrate was distilled under a reduced pressure to obtain 231 g (yield: 70%) of dimethylaminoisopropyltetramethyldisilazane ((CH₃)₂NCH₃HSiNCH(CH₃)₂Si(CH₃)₃) as a silicon precursor compound.

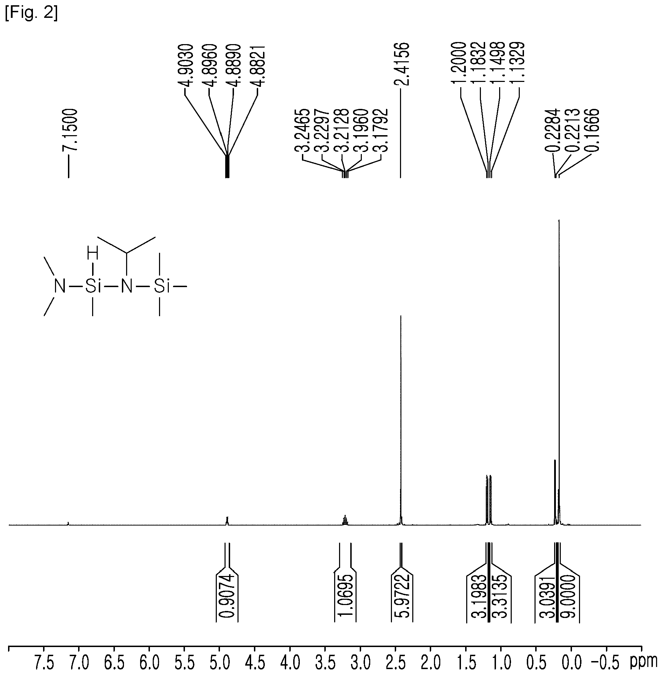

Fig. 2 shows a hydrogen nuclear magnetic resonance (¹H-NMR) spectrum of the silicon precursor compound prepared according to Example 2 of the present invention. As shown in Fig. 2, the silicon precursor compound prepared in Example 2 was confirmed to be dimethylaminoisopropyltetramethyldisilazane.

¹H NMR (C₆D₆): δ 0.16(s, 9H (-Si(***CH₃***)***₃***), 0.22(d, 3H (-SiH***CH₃***)), 1.13(m, 6H (-NCH(***CH₃***)₂)), 2.41(s, 6H (-SiN(***CH₃***)₂),) 3.17(m, 1H (-N***CH***(CH₃)₂)), 4.88(m, 1H (-Si***H***))

### [Example 3]

In Example 3, chloro-isopropyl-dimethyl-(trimethylsilyl)silane diamine of compound (16) was prepared as a silicon precursor compound.

First, for dichloro-dimethylsilanamine as a silane compound required for the preparation of a silicon precursor compound, a 1-liter flask in an anhydrous and inert atmosphere was charged with 400 g (2.95 moles) of trichloromethylsilane (SiHCl₃) and 4,200 g (59.0 moles) of n-pentane. While the temperature was maintained at -40°C, 266 g (5.91 moles) of dimethylamine ((CH₃)₂NH) was slowly added, followed by stirring for 3 hours. Upon completion of the stirring, the dimethylamine hydrochloride salt ((CH₃)₂NH₃Cl) was removed through filtration, and 297 g (2.07 moles) of dichlorodimethylsilaneamine (CH₃)₂NSiHCl₂) (yield: 70%) was obtained through distillation under a reduced pressure.

¹**H NMR** (C₆D₆): δ 2.25(s, 6H (-N**(*CH₃*)₂**)), 5.28(m, 1H (-si***H***))

In the first step of Example 3, isopropylaminotrimethylsilazane was prepared in the same manner as in Example 1.

In the second step of Example 3, a 1-liter flask in an anhydrous and inert atmosphere was charged with 200 g (1.38 moles) of isopropylaminotrimethylsilazane ((CH₃)₂CHNHSi(CH₃)₃) prepared in the first step and 593 g (6.88 moles) of hexane. While the temperature was maintained at -40°C, 402 ml (1.45 mole) of 2.5 M n-butyllithium (n-BuLi) was slowly added. The temperature of the reaction solution was then gradually raised to room temperature, followed by stirring for 12 hours at room temperature. While the temperature of the mixed solution was maintained at - 20°C again, 198 g (1.38 moles) of dichlorodimethylsilane ((CH₃)₂NSiHCl₂) was slowly added, followed by stirring for 6 hours or longer. Upon completion of the stirring, the lithium chloride (LiCl) salt was removed through filtration. The obtained filtrate was distilled under a reduced pressure to obtain 197 g (yield: 60%) of chloro-isopropyl-dimethyl-(trimethylsilyl)silane diamine ((CH₃)₂NHClSiNCH(CH₃)₂Si(CH₃)₃) as a silicon precursor compound.

¹H NMR (C₆D₆): δ 0.16(s, 9H (-Si(***CH₃***)***₃***), 1.15(m, 6H (-NCH(***CH₃***)₂)), 2.40(s, 6H (-SiN(***CH₃***)₂)), 3.20(m, 1H (-N***CH***(CH₃)₂)), 5.37(m, 1H (-Si***H***))

### [Example 4]

In Example 4, isopropyldimethyltrimethylsilylsilanediamine of compound (19) was prepared as a silicon precursor compound.

First, chloro-isopropyl-dimethyl-(trimethylsilyl)silane diamine ((CH₃)₂NHClSiNCH₂(CH₃)₂Si(CH₃)₃) required for the preparation of a silicon precursor compound was prepared in the same manner as in Example 3.

A 1-liter flask in an anhydrous and inert atmosphere was charged with 3.5 g (0.44 mole) of LiH and 452 g (6.28 moles) of tetrahydrofuran. While the temperature was maintained at 0°C, 100 g (0.42 mole) of chloro-isopropyl-dimethyl-(trimethylsilyl)silane diamine ((CH₃)₂NHClSiNCH₂(CH₃)₂Si(CH₃)₃) was slowly added. The temperature thereof was then gradually raised to room temperature, followed by stirring for 12 hours at 67°C. Upon completion of the stirring, the lithium chloride (LiCl) salt was removed through filtration. The obtained filtrate was distilled under a reduced pressure and purified to obtain 59 g (yield: 70%) of isopropyldimethyltrimethylsilylsilanediamine ((CH₃)₂NH₂SiNCH(CH₃)₂Si(CH₃)₃).

¹H NMR (C₆D₆): δ 0.16(s, 9H (-Si(***CH₃***)***₃***), 1.14(d, 6H (-NCH(***CH₃***)₂)), 2.42(s, 6H (-SiN(***CH₃)₂***)), 3.19(m, 1H (-N***CH***(CH₃)₂)), 4.80(s, 2H (-Si***H₂***))

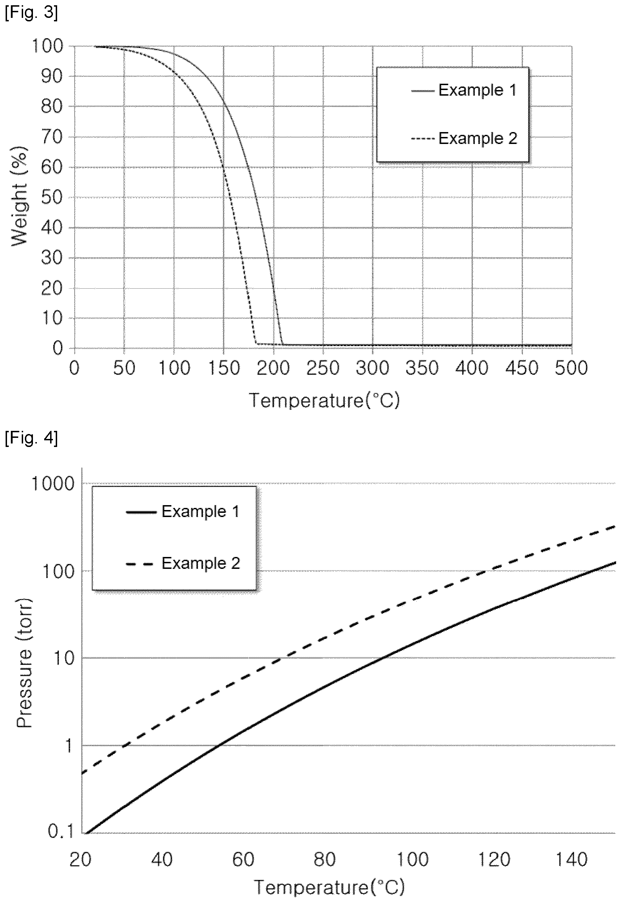

Thermogravimetric analysis (TGA) was carried out to analyze the thermal characteristics of the silicon precursor compounds prepared in Examples 1 and 2. The results are shown in Fig. 3.

As shown in Fig. 3, the silicon precursor compound of Example 1 shows volatility in various temperature ranges of 200°C or lower, between 200°C and 500°C, and 500°C or higher. In particular, the silicon precursor compound of Example 2 shows volatility in the temperature ranges of 160°C or lower, between 160°C to 500°C, and 500°C or higher, which are lower than the temperature ranges of Example 1. Thus, they are excellent silicon precursors capable of forming a silicon-containing oxide thin film and a silicon-containing nitride thin film in a wide range of temperatures.

The above results indicate that all of the silicon precursor compounds prepared according to Examples 1 and 2 show sufficient volatility to be applied to atomic layer deposition (ALD) or chemical vapor deposition (CVD).

In order to confirm that the silicon precursor compounds prepared according to Examples 1 and 2 have a vapor pressure suitable for the preparation of a silicon nitride thin film through a deposition method, their vapor pressures were measured. The results are shown in Fig. 4.

As shown in Fig. 4, all of the silicon precursor compounds of Examples 1 and 2 show a high vapor pressure of 10 Torr at about 100°C. In particular, Example 2 shows a higher vapor pressure at a lower temperature than Example 1.

The above vapor pressure results indicate that all of the silicon precursor compounds prepared according to Examples 1 and 2 show a high vapor pressure at a low temperature of about 100°C or lower, indicating a sufficient vapor pressure to be applied to atomic layer deposition (ALD) or chemical vapor deposition (CVD).

To evaluate a silicon-containing thin film formed using a silicon precursor compound prepared according to the present invention, a silicon nitride thin film was deposited on a silicon substrate by atomic layer deposition (ALD) using diethylaminoisopropyltetramethyldisilazane of Example 1 as a silicon precursor compound. In such an event, an ALD reactor in which a silicon precursor compound and a reactive gas are separately supplied in a vertical direction using a double shower head was used.

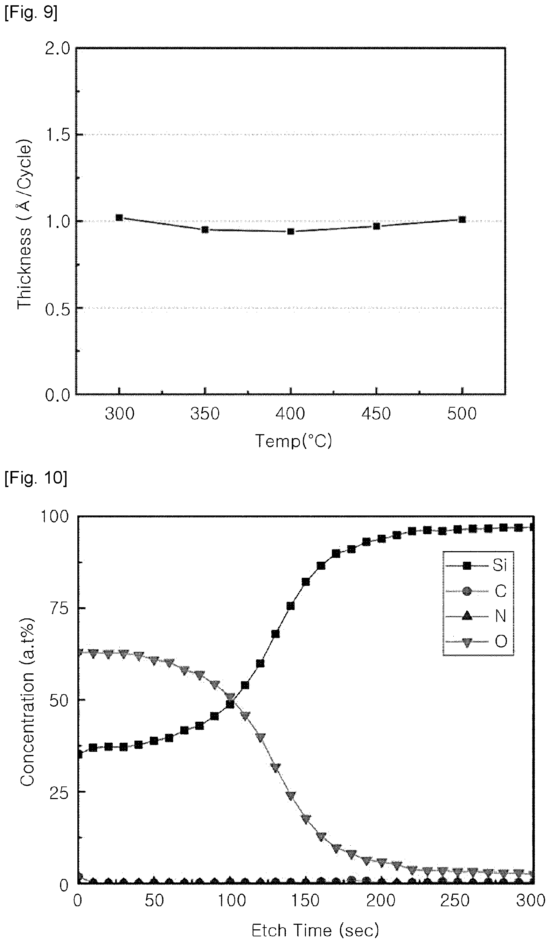

Table 1 and Fig. 9 show the specific conditions for silicon nitride thin film deposition.

**[Table 1]**

| Source | Substrate Temp. | Precursor heating | Precursor injection | Purge | | N₂ plasma | | Purge | | No. of depositions |
|---|---|---|---|---|---|---|---|---|---|---|
| Unit | °C | °C | Time (sec.) | Flow rate (sccm) | Time (sec.) | Flow rate (sccm) | Time (sec.) | Flow rate (sccm) | Time (sec.) | |
| Ex. 1 | 150-350 | 60 | 7 | 300 | 7 | 1,000 | 7 | 300 | 9 | 100 |

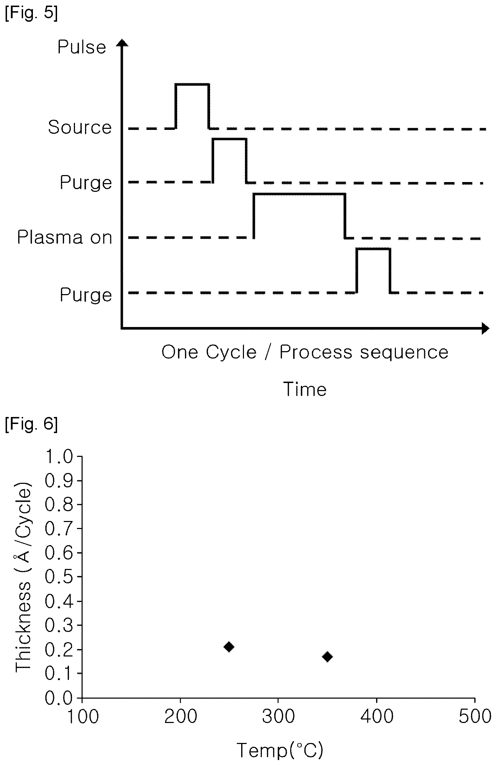

The thickness of the thin film deposited in the above manner was measured using an ellipsometer. Table 2 and Fig. 6 show the results of analyzing the characteristics of specific silicon nitride thin films.

**[Table 2]**

| Source | Substrate temp. | Deposition rate | Film thickness | N/Si |
|---|---|---|---|---|
| | °C | Å/cycle | Å | Composition ratio |
| Ex. 1 | 250 | 0.21 | 21 | 1.34 |
| | 350 | 0.17 | 17 | 1.05 |

As shown in Table 2, when the substrate temperature was 250°C, the deposition rate and film thickness were higher and thicker than when the substrate temperature was 350°C, indicating that a high deposition rate was achieved at a lower temperature, and a silicon-containing thin film with high purity was formed when the composition ratio of N/Si was examined. In addition, Fig. 6 is a graph showing the deposition rate of a silicon nitride thin film with respect to the substrate temperature. As shown in Fig. 6, the deposition rates were similar under the conditions of 250°C and 350°C.

As another example, to evaluate a silicon oxide film (SiO₂) formed using a silicon precursor compound prepared according to the present invention, a silicon oxide film was deposited on a silicon substrate by atomic layer deposition (ALD) using dimethylaminoisopropyltetramethyldisilazane of Example 2 as a silicon precursor compound. In such an event, an atomic layer deposition (ALD) reactor in which a silicon precursor compound and a reactive gas are separately supplied in a vertical direction using a double shower head was used.

In the present specification, silicon-containing thin films, SiN and SiO₂, are prepared and described as a representative example, but it is not limited thereto. Silicon-containing thin films known in the art such as SiN, SiO₂, SiOC, SiON, SiCN, and SiC can be formed.

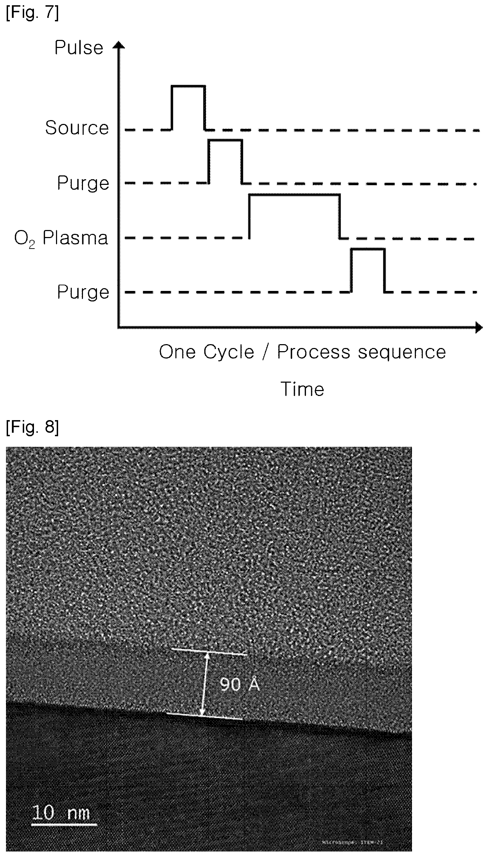

Table 3 and Fig. 7 show the specific conditions for silicon oxide film deposition.

**[Table 3]**

| Source | Substrate Temp. | Precursor heating | Precursor injection | Purge | | O₂ plasma/200 W | | Purge | | No. of depositions |
|---|---|---|---|---|---|---|---|---|---|---|
| Unit | °C | °C | Time (sec.) | Flow rate (sccm) | Time (sec.) | Flow rate (sccm) | Time (sec.) | Flow rate (sccm) | Time (sec.) | |
| Ex. 2 | 300-500 | 60 | 7 | 1,000 | 8 | 1,000 | 5 | 1,000 | 10 | 100 |

The composition of the silicon oxide film was analyzed using X-ray photoelectron spectroscopy (XPS) of the thin film deposited by the above method, and the step coating was confirmed using transmission electron microscopy (TEM). Table 4 and Figs. 8 and 9 show the results of analyzing the characteristics of the specific silicon oxide film.

**[Table 4]**

| Source | Substrate temp. | Deposition rate | Film thickness | O/Si |
|---|---|---|---|---|
| | °C | Å/cycle | Å | Composition ratio |
| Example 2 | 400 | 0.99 | 90 | 1.7 |

As shown in Table 4, the silicon oxide film formed using the silicon precursor compound of Example 2 had a thick film thickness of 90 Å, and a silicon-containing thin film with high purity was formed when the composition ratio of O/Si was examined.

Fig. 8 is a transmission electron microscope (TEM) photograph of a silicon oxide film deposited at a substrate temperature of 400°C. As shown in Fig. 8, a silicon oxide film was formed uniformly with a thickness of 90 Å.

Fig. 9 is a graph showing the deposition rate of a silicon oxide film with respect to the substrate temperature. As shown in Fig. 9, the deposition rates were similar in the temperature range of 300°C and 500°C.

Fig. 10 shows the composition of a silicon oxide film deposited at a substrate temperature of 400°C as analyzed using X-ray photoelectron spectroscopy (XPS).

As described above, the cyclodisilazane derivatives prepared according to the present invention as a silicon precursor compound are suitable for forming a silicon-containing thin film with high purity at a high deposition rate through atomic layer deposition (ALD).

The above-described embodiments are only for the purpose of describing the preferred embodiments of the present invention. The scope of the present invention is not limited to the described embodiments. Various changes, modifications, or substitutions will be possible by those skilled in the art within the technical idea and claims of the present invention. It should be understood that such embodiments fall within the scope of the present invention.

## Claims

1. A silicon precursor compound, which is represented by the following Formula 1: 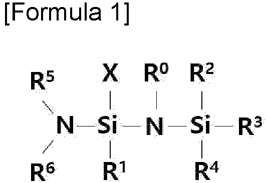 in Formula 1, R⁰, R⁵, and R⁶ are each independently a linear or branched, saturated or unsaturated hydrocarbon group having 1 to 4 carbon atoms or an isomer thereof, R¹, R², R³, and R⁴ are each independently hydrogen (H), a halogen, or a linear or branched, saturated or unsaturated hydrocarbon group having 1 to 4 carbon atoms, and X is hydrogen (H) or a halogen.

2. The silicon precursor compound of claim 1, wherein the silicon precursor compound is selected from the following compounds (1) to (36):

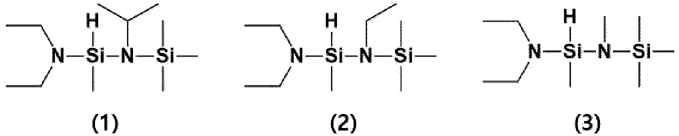

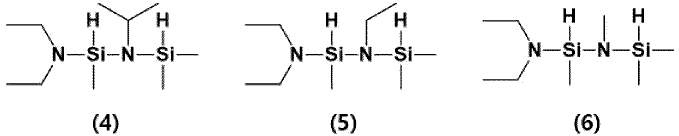

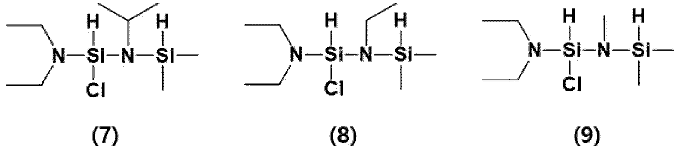

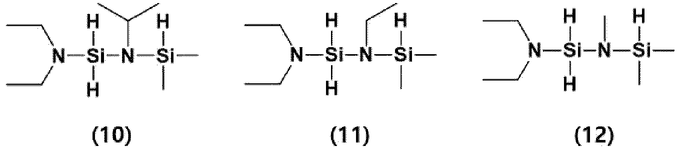

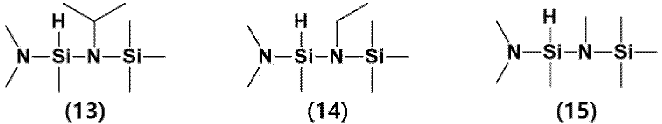

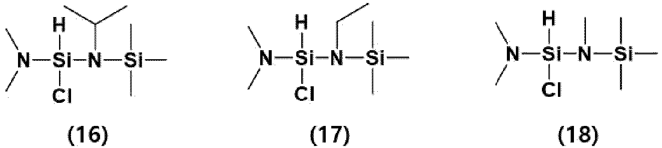

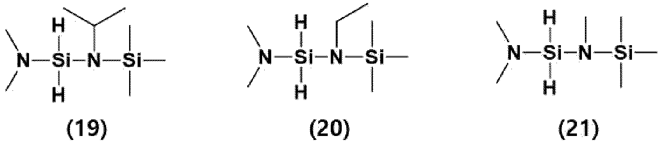

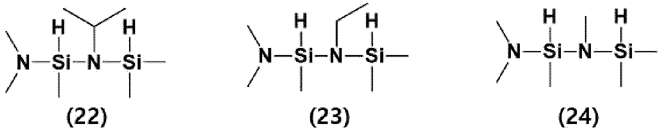

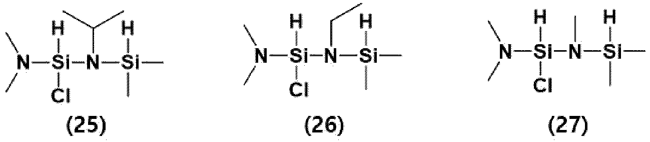

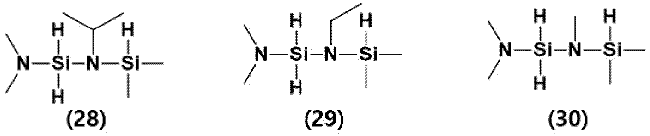

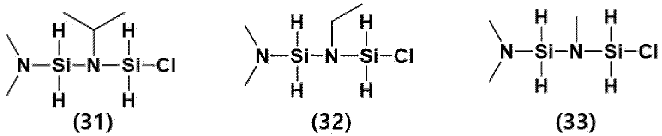

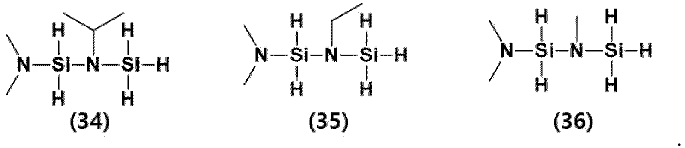

3. A method for preparing a silicon precursor compound, which comprises:
a first step of reacting a chlorosilane derivative with a primary amine to form a first compound;
a second step of reacting the first compound with an alkyl-lithium (Alkyl-Li) to form a second compound comprising lithium; and
a third step of reacting the second compound with a silane compound to prepare a silicon precursor compound represented by the following Formula 1: 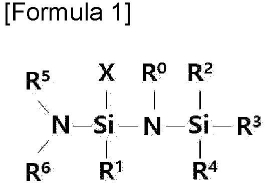
in Formula 1, R⁰, R⁵, and R⁶ are each independently a linear or branched, saturated or unsaturated hydrocarbon group having 1 to 4 carbon atoms or an isomer thereof, R¹, R², R³, and R⁴ are each independently hydrogen (H), a halogen, or a linear or branched, saturated or unsaturated hydrocarbon group having 1 to 4 carbon atoms, and X is hydrogen (H) or a halogen.

4. The method for preparing a silicon precursor compound of claim 3, wherein the first compound is a compound represented by the following Formula 7: 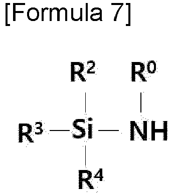 in Formula 7, R⁰ is each independently a linear or branched, saturated or unsaturated hydrocarbon group having 1 to 4 carbon atoms or an isomer thereof; and R², R³, and R⁴ are each independently hydrogen (H), a halogen, or a linear or branched, saturated or unsaturated hydrocarbon group having 1 to 4 carbon atoms.

5. The method for preparing a silicon precursor compound of claim 3, wherein, when X and R¹ in the silicon precursor compound represented by Formula 1 are each a halogen, the method comprises a fourth step of reacting it with a metal hydride.

6. The method for preparing a silicon precursor compound of claim 3, wherein the silane compound is produced by reacting a chlorosilane derivative with a secondary amine.

7. A method for preparing a silicon-containing thin film, which comprises forming a silicon-containing thin film using a silicon precursor compound represented by the following Formula 1: 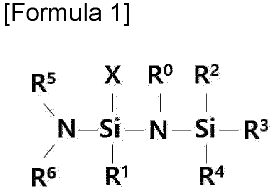 in Formula 1, R⁰, R⁵, and R⁶ are each independently a linear or branched, saturated or unsaturated hydrocarbon group having 1 to 4 carbon atoms or an isomer thereof, R¹, R², R³, and R⁴ are each independently hydrogen (H), a halogen, or a linear or branched, saturated or unsaturated hydrocarbon group having 1 to 4 carbon atoms, and X is hydrogen (H) or a halogen.

8. The method for preparing a silicon-containing thin film of claim 7, wherein the silicon precursor compound is selected from the following compounds (1) to (36):

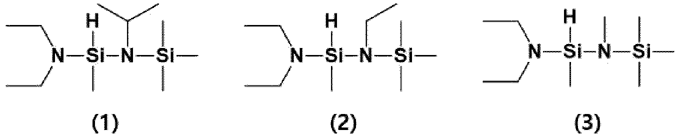

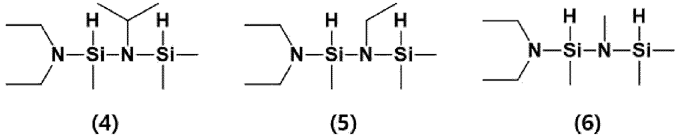

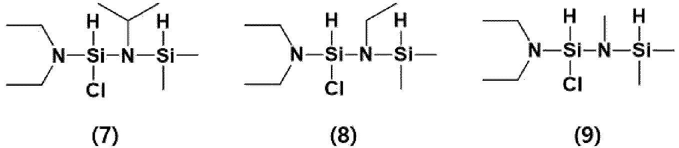

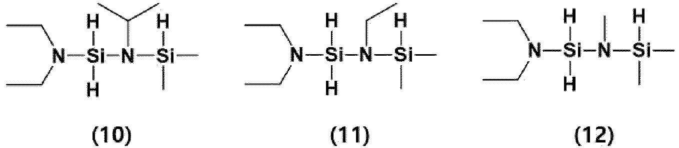

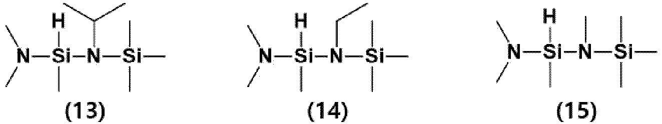

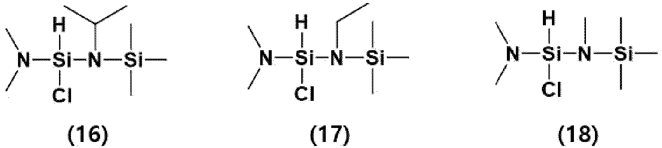

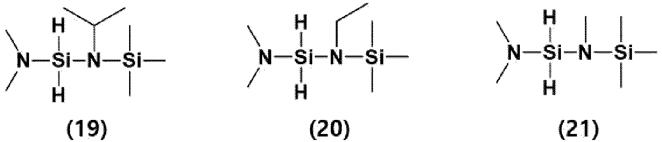

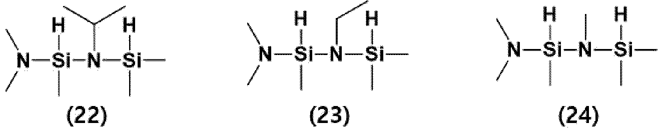

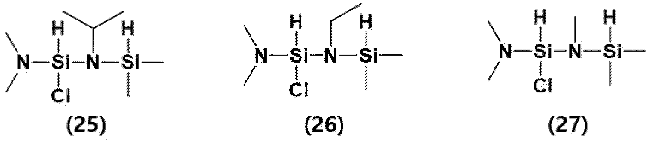

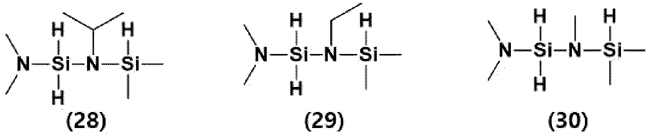

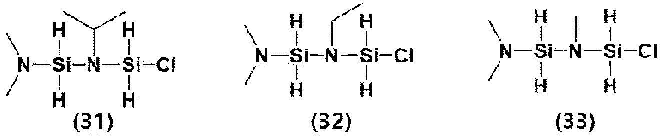

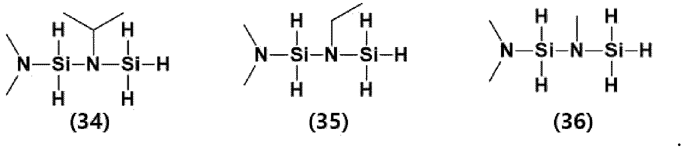

9. The method for preparing a silicon-containing thin film of claim 7, wherein the silicon-containing thin film is deposited by chemical vapor deposition (CVD) or atomic layer deposition (ALD).

10. The method for preparing a silicon-containing thin film of claim 7, wherein the silicon-containing thin film is any one selected from the group consisting of a silicon oxide film (SiO₂), a silicon oxycarbide film (SiOC), a silicon nitride film (SiN), a silicon oxynitride film (SiON), a silicon carbonitride film (SiCN), and a silicon carbonized film (SiC).

11. The method for preparing a silicon-containing thin film of claim 9, wherein the silicon-containing thin film is a silicon oxide (SiO₂) film, and the silicon oxide film is deposited by atomic layer deposition,
wherein the atomic layer deposition comprises providing a substrate to a reactor; introducing the silicon precursor compound into the reactor; purging the reactor with a purge gas; introducing an oxygen source into the reactor to react with the silicon precursor compound to form a silicon oxide film; and purging the reactor with the purge gas.

12. The method for preparing a silicon-containing thin film of claim 11, wherein the purge gas is selected from the group consisting of nitrogen, helium, argon, and mixtures thereof.

13. The method for preparing a silicon-containing thin film of claim 11, wherein the oxygen source is selected from the group consisting of oxygen, peroxide, oxygen plasma, water vapor, water vapor plasma, hydrogen peroxide, ozone source, and mixtures thereof.

14. The method for preparing a silicon-containing thin film of claim 11, wherein the oxygen source comprises plasma.

15. The method for preparing a silicon-containing thin film of claim 14, wherein the plasma is generated *in situ.*

16. The method for preparing a silicon-containing thin film of claim 11, wherein the atomic layer deposition is carried out at one or more temperatures of about 500°C or lower.

17. The method for preparing a silicon-containing thin film of claim 9, wherein the silicon-containing thin film is a silicon nitride (SiN) film, and the silicon nitride film is deposited by plasma-enhanced atomic layer deposition,
wherein the plasma-enhanced atomic layer deposition comprises providing a substrate to a reactor; introducing the silicon precursor compound into the reactor; purging the reactor with a purge gas; introducing a nitrogen-containing plasma source and an inert gas into the reactor to react with the silicon precursor compound to form a silicon nitride film; and purging the reactor with a purge gas.

18. The method for preparing a silicon-containing thin film of claim 17, wherein the nitrogen-containing plasma source is selected from the group consisting of nitrogen plasma, nitrogen and argon mixed plasma, ammonia plasma, nitrogen and ammonia mixed plasma, ammonia and helium mixed plasma, ammonia and argon mixed plasma, ammonia and nitrogen mixed plasma, NF₃ plasma, organic amine plasma, and mixtures thereof.

19. The method for preparing a silicon-containing thin film of claim 17, wherein the method is carried out at one or more temperatures of about 400°C or lower.
